# EUROPEAN PATENT APPLICATION

(11) **EP 1 011 132 A2**
(43) Date of publication of application: **21.06.2000**
(21) Application number: 99307379.0
(22) Date of filing: 17.09.1999
(51) Int. Cl.: H01L 21/48, B23K 20/00

(54) **Ultrasonic bumping of electronic components**

(30) Priority: 18.12.1998 US 215928
(71) Applicant: Ford Motor Company, Dearborn, MI 48126-2490 (US)
(72) Inventor: Pham, Cuong Van, Belleville, Michigan 48111 (US); Nuno, Rose Lynda, Detroit, Michigan 48209 (US)
(74) Representative: Messulam, Alec Moses

(57) **Abstract**

An apparatus for ultrasonically bumping a metallic bonding site 12 on a workpiece 10, comprising:
(a) a workpiece holder 20 for releasably attaching the workpiece 10 thereto;
(b) a bumping tool 30 having a bumping tip 32 with a bump cavity 34 formed therein;
(c) an ultrasonic transducer 40 coupled with the bumping tool for ultrasonically vibrating the bumping tip;
(d) means 60 for positioning a metal foil 50 atop the bonding site on the workpiece; and
(e) means 70 for moving the bumping tool between
   (i) a reset position, wherein the bumping tip 32 is disposed away from the bonding site 12 on the workpiece, and
   (ii) a bonding position, wherein the bumping tip 32 presses the metal foil 50 against the bonding site 12 on the workpiece.

## Description

The present invention relates generally to bumping of electronic components, and more particularly to ultrasonic bumping of electronic components.

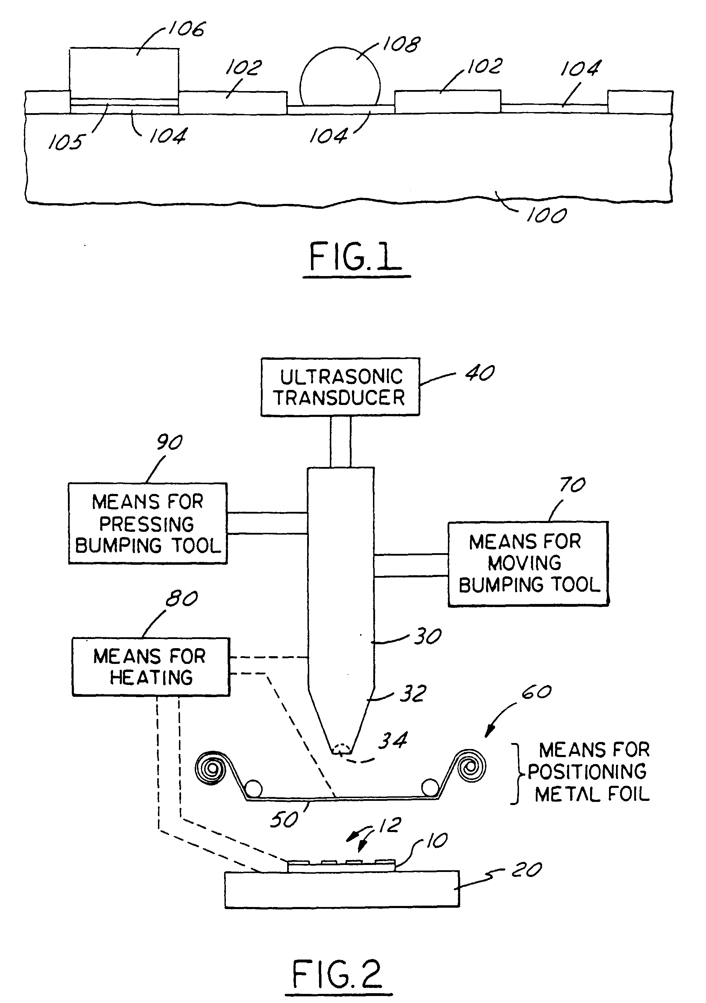

A common way of providing interconnects on electronic components such as flipchips is to provide metallic "bumps" on the component bonding pads. For example, as illustrated in FIG. 1, a semiconductor flipchip device typically comprises a silicon chip 100 with an electrically insulative passivation layer 102 thereon with apertures formed therein through which aluminium bond pads 104 are exposed. On the bond pads 104, bumps 106/108 (typically made of solder or gold) are formed, either by (1) plating/sputtering or (2) stud bumping.

The plating/sputtering method utilises a sequence of masking, plating/sputtering, stripping, and cleaning steps, requiring photolithography equipment and clean room conditions. This method is typically an additive electroless process which adds an adhesion layer atop the aluminium bond pads, then a barrier layer 105 atop the adhesion layer, and then a gold or solder bump 106 atop the barrier layer. (In some cases, the functions of the adhesion and barrier layers may be combined into a single layer 105.) The barrier layer helps to prevent the formation of undesirable intermetallic compounds between the gold bump and the adhesion layer/bond pad, thereby improving the overall bond between the gold bump and the flipchip.

A simpler process is the stud bumping method, which utilises a gold wire wirebonding machine to produce and attach gold bumps 108 to the bond pads 104. This process has the advantage of involving fewer, simpler steps and obviating the need for clean room conditions, but has the disadvantage that it does not provide a barrier layer between the bond pad 104 and the gold bump 108. Thus, while the stud bumping process is generally less expensive and less time-consuming than the plating/sputtering method, it also tends to produce bumps whose bonds to the flipchip are less reliable.

Although both of the foregoing approaches are commonly used in the electronics industry, each approach has its disadvantages. It would be desirable, therefore, to provide an alternative way of bumping electronic components which does not have these drawbacks.

With a view to mitigating at least some of the disadvantages of the prior art approaches, the present invention provides an apparatus for ultrasonically bumping a metallic bonding site on a workpiece, comprising a workpiece holder for releasably attaching the workpiece thereto; a tool having a bumping tip with a bump cavity formed therein; an ultrasonic transducer coupled with the bumping tool for ultrasonically vibrating the bumping tip; means for positioning a metal foil atop the bonding site on the workpiece; and means for moving the bumping tool between a reset position, wherein the bumping tip is disposed away from the bonding site on the workpiece, and a bonding position, wherein the bumping tip presses the metal foil against the bonding site on the workpiece.

In accordance with a second aspect of the invention, there is provided a method for ultrasonically bumping a metallic bonding site on a workpiece, comprising the steps of providing a bumping tool having a bumping tip with a bump cavity formed therein; positioning a metal foil atop the bonding site on the workpiece; pressing the bumping tip against the metal foil in contact with the bonding site; and ultrasonically vibrating the bumping tool such that the bumping tip excises a portion of the metal foil within the bump cavity and diffusively bonds the excised metal foil portion to the bonding site.

It is an advantage of the present invention that it may be used to bump electronic components in a way that permits control of the bump shape.

Another advantage of the present invention is that it combines the ease and efficiency of the stud bumping method with the barrier layer protection of the plating/sputtering method.

The invention has the still further advantage that it may be easily implemented using conventional ultrasonic bonding equipment with only slight modifications.

The invention will now be described further, by way of example, with reference to the accompanying drawings, in which:

FIG. 1 is a cross-sectional side view of a typical bumped electronic component.

FIG. 2 is a schematic side view of an apparatus for ultrasonic bumping according to the present invention.

FIGS. 3A-D are magnified side views of the ultrasonic bumping apparatus showing successive process steps for utilising the apparatus according to the present invention.

FIGS. 4A-C are magnified sectional side views of the bumping tip of the ultrasonic bumping apparatus, showing alternative bump cavity configurations.

Referring now to the drawings, FIG. 2 shows an apparatus for ultrasonically bumping a metallic bonding site 12 on a workpiece 10 according to the present invention. The bumping apparatus comprises: (a) a workpiece holder 20 for releasably attaching the workpiece 10 thereto; (b) a bumping tool 30 having a bumping tip 32 with a bump cavity 34 formed therein; (c) an ultrasonic transducer 40 coupled with the bumping tool for ultrasonically vibrating the bumping tip; (d) means 60 for positioning a metal foil 50 atop the bonding site on the workpiece; and (e) means 70 for moving the bumping tool between (e1) a reset position, wherein the bumping tip 32 is disposed away from the bonding site 12 on the workpiece, and (e2) a bonding position, wherein the bumping tip 32 presses the metal foil 50 against the bonding site 12 on the workpiece.

To assist the reader in understanding the present invention, all reference numbers used herein are summarised in the table below, along with the elements they represent:
- 10 =: Workpiece
- 12 =: (First) bonding site on the workpiece
- 14 =: Second bonding site on the workpiece
- 20 =: Workpiece holder
- 30 =: Bumping tool
- 32 =: Bumping tip
- 33 =: Face of the bumping tip
- 34 =: Bump cavity in bumping tip
- 40 =: Ultrasonic exciter/transducer
- 50 =: Supply of metal foil
- 52 =: First region/portion of metal foil
- 54 =: Second region/portion of metal foil
- 56 =: Base layer of metal foil
- 58 =: = Barrier layer of metal foil
- 59 =: Bump formed from metal foil
- 60 =: Means for positioning the metal foil
- 70 =: Means for moving the bumping tool
- 80 =: Means for heating
- 90 =: Means for pressing the bumping tool
- α =: Angle at which bumping tip face slopes inward toward cavity

The workpiece holder 20 may be a table-like structure that is either fixed or movable. The holder 20 may include pins, clips, fasteners, or the like for releasably holding the workpiece 10 in place while presenting the workpiece bonding sites 12/14 (e.g., bond pads) to the bumping tool 30. Heating elements and thermocouples (not shown) for heating and temperature control may also be included with the holder 20.

The bumping tool 30 is preferably generally elongate and has a bumping tip 32 at one end thereof, with a bump cavity 34 defined in the tip 32. The bumping tool is typically made of metal (e.g., tungsten carbide) or ceramic, and is sized and dimensioned so that a high amplitude harmonic node occurs at or near the bumping tip 32 in response to ultrasonic frequencies generated by the ultrasonic transducer/exciter 40. For example, the bumping tool may be similar to an ultrasonic "horn" used on a conventional ultrasonic welding/bonding machine.

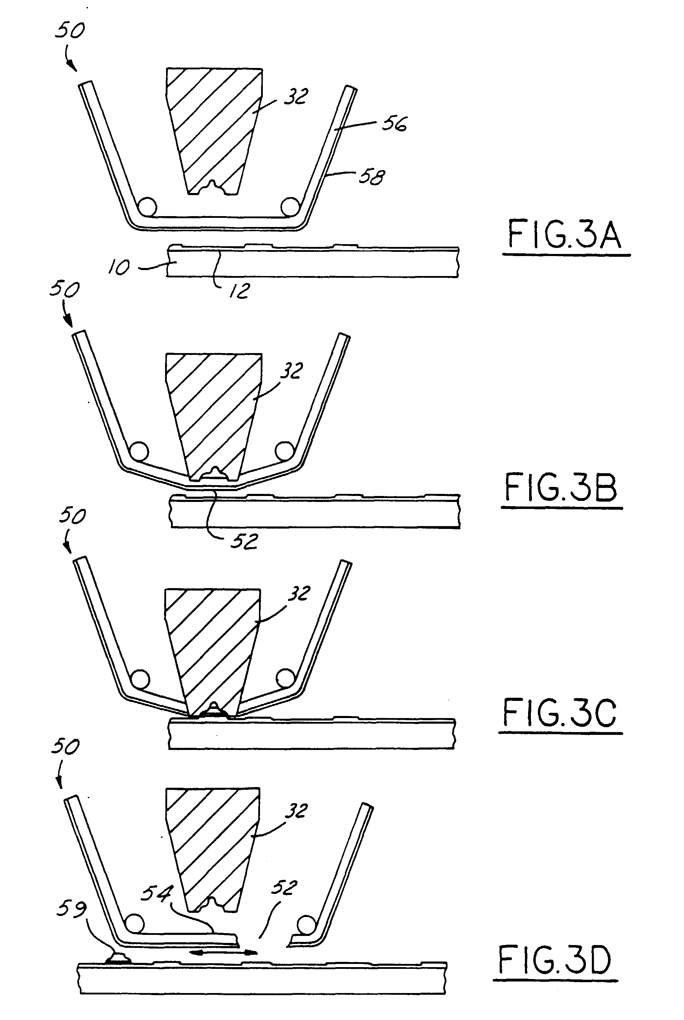

During operation of the apparatus, a workpiece 10 is fastened onto the holder 20 and a metal foil 50 is positioned atop/above the workpiece bonding sites 12/14. The foil is preferably spaced a small distance above the bond sites (e.g., less than 0.25 inch), but it may alternatively be placed directly onto the top surfaces of the bond sites, or spaced a greater distance away therefrom. The bonding tool 30 is typically positioned above and spaced apart from the foil 50, as illustrated in FIG. 3A -- this may be referred to as the "reset position" of the apparatus. Next, the bumping tool is lowered by the moving means 70 such that the bonding tip 32 and opening to the bump cavity 34 are placed in contact with the foil, such that the tip 32 presses the foil into contact with the first bonding site 12, as illustrated in FIGS. 3B-C -- this may be referred to as the "bonding position".

The means 70 for moving the tool 30 should be capable of raising and lowering the tool into the "reset" and "bonding" positions. The tool-moving means 70 may comprise something as simple as a shuttling mechanism that is controllably reciprocable between the "reset" and "bonding" positions (such as by utilising gears, cams, pneumatics, hydraulics, electromechanical/electromagnetic elements, or the like), or it may comprise something more complex such as a fully articulatable robotic manipulator, or something in between. For example, the moving means 70 may correspond to those portions of known conventional ultrasonic, thermosonic, and thermocompression bonding/welding machines which raise, lower, or otherwise position the ultrasonic horn or bonding head of such machines.

As part of the same step of lowering the tool into the "bonding" position, or as a separate subsequent step, the tip 32 is pressed firmly against the foil 50 and bonding site 12. Typically a predetermined force (e.g., 15 Newtons) is needed to produce a good bond; this force may be provided by the means 70 for moving the tool 30, or may be provided by a separate means 90 for pressing. This pressing means 90 may be a mechanical, electrical, electromechanical, electromagnetic, pneumatic, hydraulic, or other device, and should be capable of holding the bonding tip/tool in generally constant pressure against the foil/bonding site/holder stack. When the tip 32 is pressed against the foil 50 with sufficient force and the ultrasonic transducer/exciter 40 vibrates the tip 32, that portion 52 of the foil underneath the tip face 33 will be effectively excised away from the rest of the foil supply 50 and will generally fill in the bump cavity 34 in the tip of the tool, as shown in FIG. 3C. The excision of this foil portion 52 occurs either by the pressing of the tool tip, or by the ultrasonic vibration, or (preferably) by both. The foil portion 52 is bonded by the pressing of the tool tip and the ultrasonic vibration generally simultaneously. During bonding, the excised portion 52 is plastically deformed and preferably assumes the shape of the bump cavity 34; when the tool tip 32 is lifted, a bump 59 formed by the excised portion 52 generally in the shape of the bump cavity 34 is left attached to the bonding site 12. Then, the apparatus may be indexed (by moving the tool 30, the foil 50, the foil-positioning means 60, and/or the workpiece holder 20) such that the bumping tip 32 moves away from the excised portion 52 and is positioned above a second region 54 of the foil 50, with a second bond site 14 being positioned directly beneath the tip 32 and new foil section 54 (either all in one step or as a sequence of steps), as illustrated in FIG. 3D. Then the process may be repeated as desired, until all of the bonding sites have bumps 59 attached thereatop.

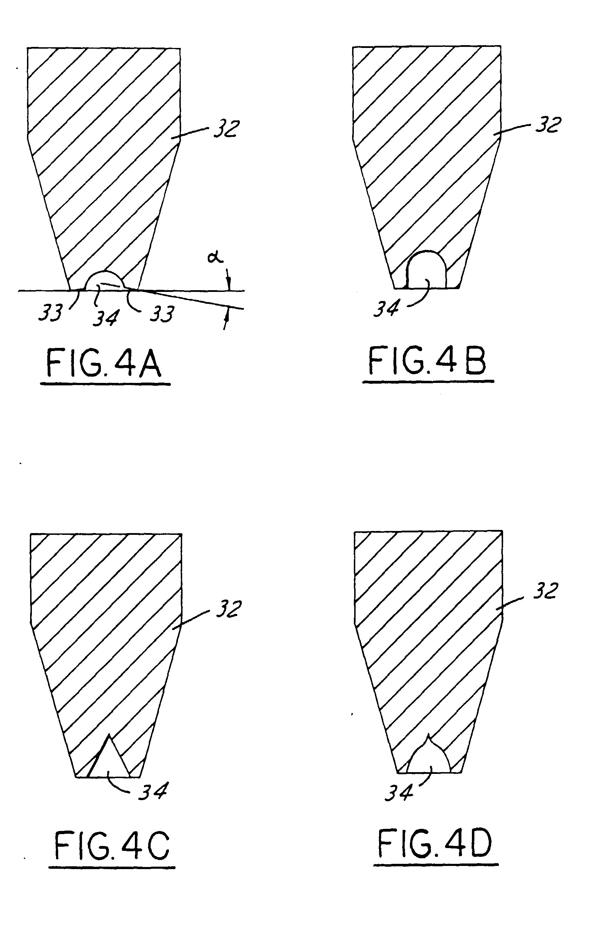

The bump cavity 34 may assume any desired shape, such as generally hemispherical (FIGS. 4A-B), generally conical (FIG. 4C), or generally teardrop-shaped (FIG., 4D). The teardrop shape of FIG. 4D provides the typical "Hershey's kiss" shape of bumps formed using traditional stud bumping. Another preferred shape is illustrated in FIGS. 3A-D, where the bump cavity 34 is shown as a generally nipple-shaped configuration. It may be advantageous in some applications to provide bumps with "points" thereatop (e.g., FIGS. 3A-D, 4C-D) so that the points may penetrate through any type of adhesive films, conformal coatings, and the like that may be used during (or before/instead of) the underfill process. Also note in FIG. 4A that the tip face 33 may be sloped inward toward the bump cavity 34 by an angle a, thus aiding in the excision of the contacted foil region 52/54 from the foil supply 50. A typical range for this angle may be 3° ≤ α ≤ 7°, although other angles may be desired for certain applications.

The apparatus may also comprise a heating means 80. This means 80 may be used to heat the tool 30, tip 32, foil 50, bonding site 12, the entire workpiece 10, and/or the holder 20, as desired. For example, the heating means may be a conducting or convecting heater element connected with the workpiece holder 20, which thereby heats the workpiece/bonding sites to a desired temperature. The heating means 80 may alternatively comprise a laser, IR source, or other source whose energy may be directed at the foil, bond site, tip, etc. Heating of the tool, tip, foil, bond sites, workpiece, and/or holder will generally be desired when the foil 50 is made of a metal different from that of the bonding sites 12; otherwise heating might not be required. For example, if the bond sites are aluminium bond pads, then the foil could be an aluminium foil and aluminium bumps may be formed ultrasonically (not thermosonically) atop the pads. However, in most cases the bump will be made of a metal different from that of the bonding sites, so some amount of heating will be beneficial.

To provide the same barrier layer advantage provide by the aforementioned plating/sputtering bump-forming process, a two-or-more-layer foil 50 may be used. As shown in FIGS. 3A-D, the foil 50 may comprise a base layer 56 made of the metal which most of the bump is to be made of, sandwiched with a barrier layer 58 of another suitable metal which will prevent or reduce the formation of intermetallics between the base layer bumps and the bond pads. For example, the base layer 56 may be a 1- to 2-mil-thick ribbon/sheet of gold, tin/lead, or the like, with the barrier layer 58 being a 500- to 1000-angstrom-thick layer of tungsten, tungsten/titanium, chromium, palladium/tungsten, or the like. Such a two-layer foil may be provided by sputtering or otherwise depositing the thin barrier layer 58 onto the thicker base layer 56. The foil 50 should be oriented by the foil-positioning means 60 such that the barrier layer side faces the bonding sites 12/14 and the base layer side 56 faces the bonding tip 32. Regardless of whether single or double/multi-layer foils are used, the surface of the foil facing the bond sites should be made of a metal that is ultrasonically bondable to the bond sites without significant formation of intermetallic compounds therebetween.

The foil-positioning means 60 may be a single- or multi-sheet feeding system, or a feed roller/take-up roller system (as illustrated in FIG. 2), or any other system or mechanism for positioning the foil sheet(s) into position as described above. The positioning means 60 may be fixed or movable, so long as relative motion is provided between the bonding tip 32 and the foil 50, so that once a given foil section 52 has been excised and formed into a bump 59, the foil, tool, and/or workpiece holder may be indexed so as to present the next foil section 54 underneath the bonding tip 32.

Test results indicate that the apparatus and method of the present invention are capable of producing very robust bumps and bonds. One test involved the use of a Delvotek Model 6320 ultrasonic bonder, household REYNOLDS WRAP(aluminium foil, and an integrated circuit (IC) having eight aluminium I/O bond pads. The bonding tip had a 25-mil-diameter nipple-shaped bump cavity therein similar to FIGS. 3A-D. The IC was mounted to a rigid workpiece holder heated to 150°C, with bonder settings of: energy = 0.8 Watts, frequency = 60 kHz, force = 45 grams, and bonding time = 80 milliseconds. In a second test, the same bonder and foil were used on a silver-coated FR4 coupon (i.e., silver atop copper bonding pads). In this case, an 18-mil-diameter nipple-shaped bump cavity was used, along with the workpiece holder being heated to 180°C and bonder settings of: energy = 0.8 Watts, frequency = 60 kHz, force = 45 grams, and bonding time = 100 milliseconds. In both cases, each bump assumed the shape of the bump cavity used, with all bumps being well bonded to their respective bond sites.

The range of bonding parameters may vary according to the materials used, material thicknesses, bonding tool size and configuration, bump configuration, and the like. Typical bonding parameter ranges may be as follows:

| Parameter | Range |
|---|---|
| Power | 0.5 - 2.0 Watts |
| Ultrasonic frequency | 60 - 120 kHz |
| Bonding time | 30 - 100 milliseconds |
| Pressing force | 25 - 100 grams |
| Workpiece preheat temperature | Ambient to 300°C |
| Bonding environment | Ambient or inert gas |

It will be clear that a conventional ultrasonic bonder may be modified to provide the apparatus of the present invention. The modifications include adding a bump cavity 34 to the tool tip 32 (which may require some reshaping/retuning of the horn) and adding a foil-positioning system or mechanism 60. All of the other elements needed -- i.e., the ultrasonic transducer 40, the means 70 for moving the bumping tool/horn into position, the means 90 for pressing the bumping tool/horn, the workpiece holder 20, and the optional means 80 for heating -- are normally included in conventional bonder systems.

## Claims

1. An apparatus for ultrasonically bumping a metallic bonding site on a workpiece, comprising:
(a) a workpiece holder (20) for releasably attaching the workpiece (10) thereto;
(b) a bumping tool (30) having a bumping tip (32) with a bump cavity (34) formed therein;
(c) an ultrasonic transducer (40) coupled with said bumping tool (30) for ultrasonically vibrating said bumping tip (32);
(d) means (60) for positioning a metal foil (50) atop the bonding site (12) on the workpiece (10); and
(e) means (70) for moving said bumping tool (30) between
(i) a reset position, wherein said bumping tip (32) is disposed away from the bonding site (12), and
(ii) a bonding position, wherein said bumping tip (32) presses the metal foil (50) against the bonding site (12).

2. An apparatus as claimed in claim 1, further including means (90) for pressing said bumping tip (32) against the metal foil (50) and the bonding site (12) in said bonding position.

3. An apparatus as claimed in claim 1 or 2, wherein said bumping tool (30) is made of metal or ceramic.

4. An apparatus as claimed in any preceding claim, wherein said bumping tool (30) is generally elongate.

5. An apparatus as claimed in any preceding claim, further including means (80) for heating at least one of said bumping tip (32), said workpiece holder (20), said metal foil (50), and the workpiece (10).

6. An apparatus as claimed in any preceding claim, wherein said bump cavity (34) is generally hemispherical, conical, nipple-shaped or teardrop-shaped.

7. An apparatus as claimed in any preceding claim, wherein said means (60) for positioning includes a supply of metal foil (50).

8. An apparatus as claimed in claim 7, wherein said metal foil (50) is made of a metal that is ultrasonically bondable to the bonding site (12) without the significant formation of intermetallic compounds therebetween.

9. An apparatus as claimed in claim 7 or 8, wherein the metal foil (50) includes a layer of barrier metal attached thereto on the side thereof facing the bonding site (12).

10. An apparatus as claimed in any preceding claim, wherein the face of the bumping tip (32) slopes inward toward said bump cavity (34).

11. A method for ultrasonically bumping a metallic bonding site on a workpiece, comprising the steps of:
(a) providing a bumping tool having a bumping tip with a bump cavity formed therein;
(b) positioning a metal foil atop the bonding site on the workpiece;
(c) pressing the bumping tip against the metal foil in contact with the bonding site; and
(d) ultrasonically vibrating the bumping tool such that the bumping tip excises a portion of the metal foil within the bump cavity and diffusively bonds the excised metal foil portion to the bonding site.

12. A method according to claim 11, wherein said bump cavity is generally hemispherical, conical, nipple-shaped, or teardrop-shaped.

13. A method according to claim 11 or 12, wherein step (d) causes the excised metal foil portion to generally conform in shape with the bump cavity.
